# EUROPEAN PATENT APPLICATION

(11) **EP 3 561 882 A1**
(43) Date of publication of application: **30.10.2019**
(21) Application number: 18197130.0
(22) Date of filing: 27.09.2018
(51) Int. Cl.: H01L 31/18, H01L 21/67, H01L 21/673, H01L 21/677, C23C 14/50, C23C 14/56

(54) **DOUBLE-SIDED COATING APPARATUS AND CARRIER PLATE PROCESSING UNIT THEREOF**

(30) Priority: 24.04.2018 CN 201820596729 U
(71) Applicant: Beijing Juntai Innovation Technology Co., Ltd, 100176 Beijing (CN)
(72) Inventor: YANG, Bin, Beijing, Beijing 100176 (CN)
(74) Representative: Branca, Emanuela

(57) **Abstract**

A double-sided coating apparatus and a carrier plate processing unit thereof are disclosed according to the present application. The carrier plate processing unit includes an additional chamber (10) in communication with a working chamber (4); and a processing device (101) configured to move the carrier plate (1) in the working chamber (4) to the additional chamber (10). The carrier plate processing unit according to the present application has the processing device arranged in the additional chamber and has the additional chamber in communicate with the working chamber.

## Description

### FIELD

The present application relates to the technical field of photovoltaic module manufacturing devices, and particularly to a double-sided coating apparatus and a carrier plate processing unit thereof.

### BACKGROUND

Currently, in a double-sided coating apparatus, a cell is carried by a carrier plate during the entire transfer process.

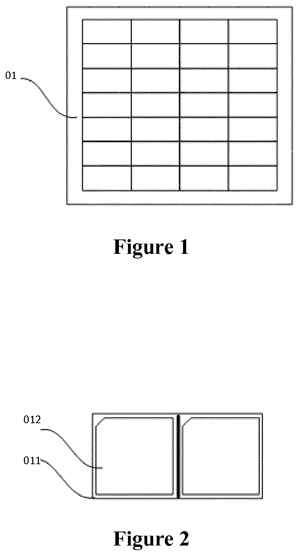

As shown in Figure 1, Figure 2 and Figure 3, a carrier plate 01 has a frame structure, which supports and positions the edge of a cell in order to coat upper and lower surfaces of the cell. The carrier plate 01 is composed of a bottom plate 011 and a cover plate 013. The cell is placed over a groove 012 of the bottom plate 011 of the carrier plate, and is then mounted onto the bottom plate 011 by the cover plate 013 through a positioning pin and a hole to fix the cell. The cover plate 013 has a deposition window 014.

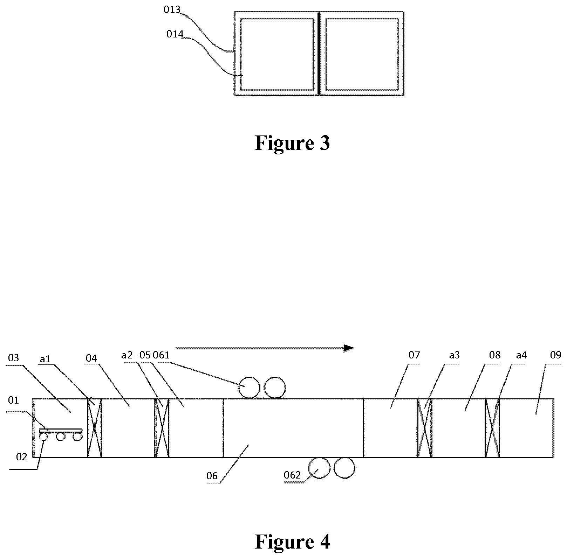

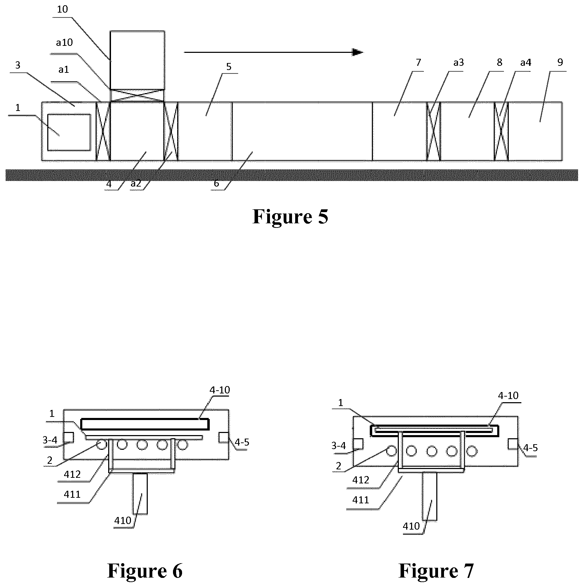

As shown in Figure 4 and Figure 5, in the double-sided coating apparatus, the carrier plate 01 sequentially passes through a cell inlet chamber 03, a front isolation chamber 04, a front cushion chamber 05, a process chamber 06, a rear cushion chamber 07, a rear isolation chamber 08 and a cell outlet chamber 09 in the process flow direction. A first gate valve a1 is provided between the cell inlet chamber 03 and the working chamber 04, a second gate valve a2 is provided between the front isolation chamber 04 and the front cushion chamber 05, a third gate valve a3 is provided between the rear cushion chamber 07 and the rear isolation chamber 08, and a fourth gate valve a4 is provided between the rear isolation chamber 08 and the cell outlet chamber 09. Since the cell is thin and has a thickness only ranging from 180um to 200um, simply a periphery of the cell is in contact with the carrier plate 01 and other portions thereof are completely suspended on the hollowed-out carrier plate 01.

After the carrier plate 01 enters the cell inlet chamber 03, a vacuum process operation is performed, and the cell inlet chamber 03 is required to be vacuumized. Since a suction outlet is arranged at the bottom of the cell inlet chamber 03, there is a pressure difference between an upper surface and a lower surface of the cell when the vacuum is applied, and the cell is easily broken in this procedure. Moreover, the cell may be heated in the cell inlet chamber 03, and during the heating process, the cell may also be broken due to deformation of the carrier plate 01 or the cell.

Since the process chamber 06 is used as a coating deposition chamber, which has an upper coating device 061 and a lower coating device 062, there may be a hole in the middle of the carrier plate 01 if the cell on the carrier plate 01 is broken. During the coating process, a film layer of the upper coating device 061 may be coated on the lower surface of the cell through the hole, and in turn a film layer of the lower coating device 062 may be coated on the upper surface of the cell, resulting in a process failure of the cell close to the hole of the carrier plate.

### SUMMARY

According to one aspect of the present application, a carrier plate processing unit is provided, wherein the carrier plate processing unit includes:
an additional chamber in communication with a working chamber; and
a processing device configured to move a carrier plate in the working chamber into the additional chamber.

According to one aspect of the present application, a double-sided coating apparatus is provided, wherein the double-sided coating apparatus includes the carrier plate processing unit according to the above aspect.

### BRIEF DESCRIPTION OF THE DRAWINGS

For more clearly illustrating technical solutions in embodiments of the present application or in the conventional technology, drawings referred to describe the embodiments or the conventional technology will be briefly described hereinafter. Apparently, the drawings in the following description are only some examples of the present application, and for the person skilled in the art, other drawings may be obtained based on these drawings without any creative efforts.
Figure 1 is a schematic view showing the structure of a carrier plate in the conventional technology;
Figure 2 is a schematic view showing the structure of a bottom plate of the carrier plate in the conventional technology;
Figure 3 is a schematic view showing the structure of a cover plate of the carrier plate in the conventional technology;
Figure 4 is a schematic view showing a first structure of a double-sided coating apparatus in the conventional technology;
Figure 5 is a schematic view showing the structure of a double-sided coating apparatus according to an embodiment of the present application;
Figure 6 is a schematic structural view showing a lifting device according to an embodiment of the present application in a first state;
Figure 7 is a schematic structural view showing the lifting device according to an embodiment of the present application in a second state;
Figure 8 is a schematic structural top view of a carrier plate transferred in a working chamber according to an embodiment of the present application;
Figure 9 is a schematic structural view of a carrier plate processing unit according to an embodiment of the present application in a first state;
Figure 10 is a schematic structural view of a carrier plate processing unit according to an embodiment of the present application in a second state; and
Figure 11 is a schematic structural view of a carrier plate processing unit according to an embodiment of the present application in a third state.

### DETAILED DESCRIPTION

A carrier plate processing unit is disclosed according to the present application, to ensure the coating effect and improve the coating efficiency. A double-sided coating apparatus including the above carrier plate processing unit is further disclosed according to the present application.

The technical solutions in the embodiments of the present application are described clearly and completely hereinafter in conjunction with the drawings in the embodiments of the present application. Apparently, the described embodiments are only a part of the embodiments of the present application, rather than all embodiments. Based on the embodiments in the present application, all of other embodiments, acquired by the person skilled in the art without any creative efforts, fall into the scope of protection of the present application.

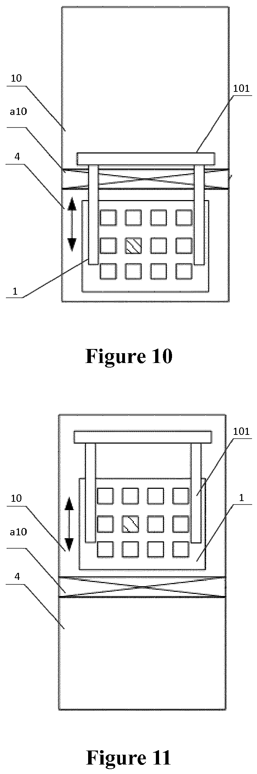

As shown in Figure 5, Figure 9, Figure 10 and Figure 11, a carrier plate processing unit is provided according to an embodiment of the present application, which includes: an additional chamber 10 in communication with a working chamber 4; and a processing device 101 configured to move a carrier plate 1 in the working chamber 4 into the additional chamber 10.

The carrier plate processing unit according to an embodiment of the present application has the processing device 101 arranged in the additional chamber 10 and has the additional chamber 10 in communication with the working chamber. Since the working chamber 4 is arranged in front of a process chamber 6 in the process flow direction, by moving the carrier plate 1 in the working chamber 4 to the additional chamber 10 through the processing device 101, the carrier 1 having fragments is effectively prevented from entering the process chamber 6 and the fragments is prevented from falling onto a lower coating device in the process chamber 6, thus ensuring the coating effect; and also the operation of opening chamber is avoided, thus improving the coating efficiency.

It can be understood that, the working chamber 4 can be arranged in front of the process chamber 6, in this way, the carrier plate 1 passes through the working chamber 4 and then passes through the process chamber 6 in the process flow direction. Apparently, the additional chamber 10 may be arranged in front of the process chamber 6, or may also be arranged beside a checking chamber or beside the process chamber, thus the fragments may be moved into the additional chamber timely when being detected in any chamber in order to avoid adversely affecting the subsequent process or to save the process time.

In this embodiment, the processing device 101 is arranged in the additional chamber 10, and the processing device 101 a manipulator that can extend into the working chamber 4 to take the carrier plate 1. The processing device 101 is optionally embodied as a manipulator. With the manipulator extending into the working chamber 4 to take the carrier plate 1 with fragments and moving the carrier plate 1 with fragments into the additional chamber 10, the carrier plate 1 with fragments is moved conveniently. It is also possible to provide a pushing device capable of pushing the carrier plate 1 into the additional chamber 10 in the working chamber 4, which can also move the carrier plate 1 in the working chamber 4 into the additional chamber 10.

As shown in Figure 5, the arrangement direction of the additional chamber 10 and the working chamber 4 is perpendicular to the process flow direction of the carrier plate 1; and the process flow direction of the carrier plate 1 is a direction from the working chamber 4 to the process chamber 6. With the above arrangement, it is avoided that the additional chamber 10 and the carrier plate 1 need to pass through the chambers (such as a cell inlet chamber 3 or a front cushion chamber 5, etc..) in the process flow direction, which facilitates the structural arrangement of the double-sided coating apparatus and reduces the improvement cost of double-sided coating apparatus.

Further, a fragment detection device is provided in the working chamber 4 to detect whether or not there are any fragments on the carrier plate. It is also possible to provide a fragment detection device in a chamber located in front of the working chamber 4. With the above arrangement, the detection operation is facilitated. Or, the working chamber 4 is provided with an observation window, and the carrier plate 1 in the working chamber 4 is detected by human observation or by an external device, and the external device can detect the state whether the carrier plate 1 in the working chamber 4 has fragments through the observation window.

A double-sided coating apparatus is further provided according to an embodiment of the present application, which includes the carrier plate processing unit according to any one of the above described aspects. Since the above carrier plate processing unit has the above-described technical effects, the double-sided coating apparatus including the above carrier plate processing unit should also have the same technical effects, which are not repeatedly described herein.

Optionally, the working chamber 4 is a front isolation chamber, which facilitates the structural arrangement. Or the front cushion chamber 5 or the cell inlet chamber 3 may be used as the working chamber 4, and it is only necessary to ensure that the working chamber 4 is arranged in front of the process chamber 6.

As shown in Figure 6 and Figure 7, the working chamber 4 is provided with a working chamber inlet 3-4 for the carrier plate 1 to enter the working chamber 4 in the process flow direction, a working chamber outlet 4-5 for the carrier plate 1 to be moved out of the working chamber 4 in the process flow direction, and an additional outlet 4-10 for the carrier plate 1 to move into the additional chamber 10.

In this embodiment, the working chamber 4 is an isolation chamber, therefore, the working chamber inlet 3-4 communicates the cell inlet chamber 3 with the working chamber 4; and the working chamber outlet 4-5 communicates the working chamber 4 with the front cushion chamber 5.

In this embodiment, the working chamber inlet 3-4 is located on the same level as the working chamber outlet 4-5, there is a height difference between the additional outlet 4-10 and the working chamber outlet 4-5, and the carrier plate 1 with fragments can be aligned with the additional outlet 4-10. The processing device 101 is a translational single-axis manipulator that can enter the working chamber 4 via the additional outlet 4-10. Since the working chamber inlet 3-4 is on the same level as the working chamber outlet 4-5, during the process of the carrier plate 1 being transferred on the transfer wheel 2 in the working chamber 4, the carrier plate 1 is transferred by the transfer wheel 2 to enter the working chamber 4 via the working chamber inlet 3-4 and is moved out of the working chamber 4 via the working chamber outlet 4-5 by the transferring operation of the transfer wheel 2. There is a height difference between the additional outlet 4-10 and the working chamber outlet 4-5, such that the carrier plate 1 with fragments can be aligned with the additional outlet 4-10, which prevents the carrier plate 1 with fragments from interfering with the transfer device (such as the transfer wheel 2) in the process of being moved into the additional chamber 10.

Optionally, in this embodiment, the additional outlet 4-10 is above the working chamber outlet 4-5, and a lifting device capable of lifting the carrier plate 1 to a position horizontally aligned with the additional outlet 4-10 is further provided in the working chamber 4. With the above arrangement, it is convenient to move the carrier plate 1 out of the working chamber 4. The transfer wheel 2 in the working chamber 4 may also be embodied as a lifting transfer wheel 2 that can lift and decline. The additional outlet 4-10 may be above the working chamber outlet 4-5, and the additional outlet 4-10 may also be lower than the working chamber outlet 4-5.

As shown in Figure 6, Figure 7 and Figure 8, the lifting device includes a lifting drive unit 410, a connection plate 411 connected to a driving end of the lifting drive unit 410, and a lifting column 412 arranged at a side of the connection plate 411 away from the lifting drive unit 410. For preventing the lifting column 412 from interfering with the transfer wheel 2 for transferring the carrier plate, the lifting column 412 is arranged to be capable of passing through a gap between two adjacent transfer wheels 2 in the working chamber 4. With the above arrangement, it is ensured that the lifting device props the carrier plate 1 to the position horizontally aligned with the additional outlet 4-10, and the structure compactness is improved. The lifting device may also be configured as a device for the lifting transfer wheel 2.

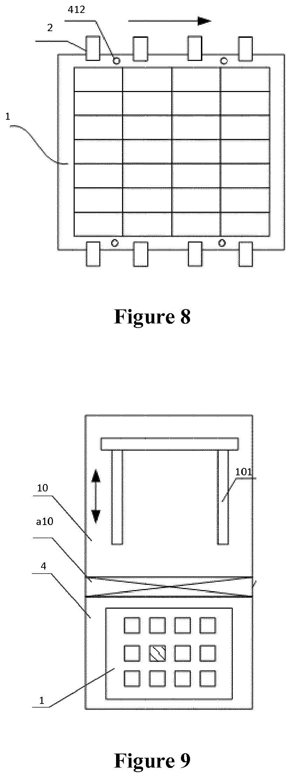

In this embodiment, the lifting drive unit 410 is a lifting cylinder, and may also be configured as a linear motor. As shown in Figure 8, the number of the lifting columns 412 is optionally four, and when performing the lifting operation to the carrier plate 1, the lifting columns 412 are in contact with the frame of the carrier plate 1.

In another embodiment, an additional outlet 4-10 for the carrier plate 1 to be moved into the additional chamber 10 is provided in the working chamber 4. The processing device 101 is a manipulator that can enter the working chamber 4 via the additional outlet 4-10, and the manipulator is a multi-axis manipulator that can achieve translation and lifting. This is also convenient to move the carrier plate 1 to the additional chamber 10.

Optionally, a gate valve is provided between two adjacent chambers.

As shown in Figure 5, in the double-sided coating apparatus, the carrier plate 1 sequentially passes through the cell inlet chamber 3, the working chamber 4 (front isolation chamber), the front cushion chamber 5, the process chamber 6, a rear cushion chamber 7, a rear isolation chamber 8 and a cell outlet chamber 9 in the process flow direction. In order to ensure the vacuum requirements and the process environment requirements of the chambers, the chambers are arranged to be sealed from each other, and are optionally sealed by a septum. In order to enable the carrier plate to pass through the septum, each of the septa is provided with a passage opening through which the carrier plate passes, and a sealing gate valve is provided at the passage opening. The gas valve is configured to seal the passage opening in the carrier plate. For example, in this embodiment, a first gate valve a1 is provided between the cell inlet chamber 3 and the working chamber 4, a second gate valve a2 is provided between the working chamber 4 and the front cushion chamber 5, a third gate valve a3 is provided between the rear cushion chamber 7 and the rear isolation chamber 8, and a fourth gate valve a4 is provided between the rear isolation chamber and the cell outlet chamber 9, thus ensuring the independent operation of the respective chambers and avoiding mutual interference.

Optionally, an additional gate valve a10 is provided between the working chamber 4 and the additional chamber 10, which effectively ensures the independent use of the working chamber 4.

The above embodiments are described in a progressive manner. Each of the embodiments is mainly focused on describing its differences from other embodiments, and references may be made among these embodiments with respect to the same or similar portions among these embodiments.

Based on the above description of the disclosed embodiments, the person skilled in the art is capable of carrying out or using the present application. It is obvious for the person skilled in the art to make many modifications to these embodiments. The general principle defined herein may be applied to other embodiments without departing from scope of the present application. Therefore, the present application is not limited to the embodiments illustrated herein, but should be defined by the broadest scope consistent with the principle and novel features disclosed herein.

## Claims

1. A carrier plate processing unit, comprising:
an additional chamber (10) in communication with a working chamber (4); and
a processing device (101) configured to move a carrier plate (1) in the working chamber (4) into the additional chamber (10).

2. The carrier plate processing unit according to claim 1, wherein the processing device (101) is arranged in the additional chamber (10) and is a manipulator capable of extending into the working chamber (4) to take the carrier plate (1).

3. The carrier plate processing unit according to claim 1, wherein an arrangement direction of the additional chamber (10) and the working chamber (4) is perpendicular to a process flow direction of the carrier plate (1), and
the process flow direction of the carrier plate (1) is a direction from the working chamber (4) to the process chamber (6).

4. The carrier plate processing unit according to any one of claims 1 to 3, wherein a fragment detection device is provided in the working chamber (4) and is configured to detect whether there are fragments on the carrier plate (1).

5. A double-sided coating apparatus, comprising the carrier plate processing unit according to any one of claims 1 to 4.

6. The double-sided coating apparatus according to claim 5, wherein the working chamber (4) is a front isolation chamber.

7. The double-sided coating apparatus according to claim 5, wherein the working chamber (4) is provided with a working chamber inlet (3-4) for the carrier plate (1) to enter the working chamber (4) in the process flow direction, a working chamber outlet (4-5) for the carrier plate (1) to be moved out of the working chamber (4) in the process flow direction, and an additional outlet (4-10) for the carrier plate (1) to be moved into the additional chamber (10).

8. The double-sided coating apparatus according to claim 7, wherein the working chamber inlet (3-4) is located on the same level as the working chamber outlet (4-5), a height difference is arranged between the additional outlet (4-10) and the working chamber outlet (4-5), and the carrier plate (1) with fragments is alignable with the additional outlet (4-10), and
the processing device (101) is a translational single-axis manipulator capable of entering the working chamber (4) through the additional outlet (4-10).

9. The double-sided coating apparatus according to claim 7, wherein each of the working chamber inlet (3-4), the working chamber outlet (4-5) and the additional outlet (4-10) is provided with a sealing gate valve.

10. The double-sided coating apparatus according to claim 7, wherein the additional outlet (4-10) is above the working chamber outlet (4-5), and a lifting device capable of lifting the carrier plate (1) to a position horizontally aligned with the additional outlet (4-10) is provided in the working chamber (4).

11. The double-sided coating apparatus according to claim 10, wherein the lifting device comprises:
a lifting drive unit (410);
a connection plate (411) connected to a driving end of the lifting drive unit (410); and
a lifting column (412) arranged on a side of the connection plate (411) away from the lifting drive unit (410).

12. The double-sided coating apparatus according to claim 5, wherein the working chamber (4) is provided with an additional outlet (4-10) for the carrier plate (1) to be moved into the additional chamber (10), and
the processing device (101) is a manipulator capable of entering the working chamber (4) through the additional outlet (4-10), and the manipulator is a multi-axis manipulator capable of achieving translation and lifting.

13. The double-sided coating apparatus according to any one of claims 5 to 12, wherein an additional gate valve (a10) is provided between the working chamber (4) and the additional chamber (10).
